# EUROPÄISCHE PATENTSCHRIFT

(11) **EP 1 444 699 B1**
(45) Veröffentlichungstag und Bekanntmachung des Hinweises auf die Patenterteilung: **09.04.2008**
(21) Anmeldenummer: 02776870.4
(22) Anmeldetag: 06.11.2002
(51) Int. Cl.: G11C 29/00

(54) **VERFAHREN ZUR REKONFIGURATION EINES SPEICHERS**
METHOD FOR THE RECONFIGURATION OF A MEMORY
PROCEDE DE RECONFIGURATION D'UNE MEMOIRE

(30) Priorität: 12.11.2001 DE 10155449
(43) Veröffentlichungstag der Anmeldung: 11.08.2004
(73) Patentinhaber: Rieger, Martin, 85748 Garching (DE)
(72) Erfinder: Rieger, Martin, 85748 Garching (DE)
(86) Internationale Anmeldenummer: PCT/DE2002/004110
(87) Internationale Veröffentlichungsnummer: WO 2003/043023

(56) Entgegenhaltungen:
- EP-A- 0 554 901
- US-A- 6 067 259
- HANDA K ET AL: "A reconfiguration algorithm for memory arrays containing faulty spares" INTERNATIONAL TECHNICAL CONFERENCE ON CIRCUITS/SYSTEMS, COMPUTERS AND COMMUNICATIONS (ITC-CSCC'99), NIIGATA, JAPAN, 13-15 JULY 1999, Bd. E83-A, Nr. 6, Seiten 1123-1130, XP002233163 IEICE Transactions on Fundamentals of Electronics, Communications and Computer Sciences, June 2000, Inst. Electron. Inf. & Commun. Eng, Japan ISSN: 0916-8508

## Beschreibung

Die vorliegende Erfindung bezieht sich auf ein Verfahren zur Rekonfiguration eines Speichers, um fehlerhafte Speicherzellen durch nicht-fehlerhafte Speicherzellen in dem Speicher zu ersetzen. Insbesondere bezieht sich die vorliegende Erfindung auf ein Verfahren unter Verwendung eines rekonfigurierbaren Speichers, der einen oder mehrere reguläre (nicht-redundante) Bereiche mit einer Mehrzahl von Speicherzellen und redundante Bereiche mit einer Mehrzahl von redundanten Speicherzellen umfasst, wobei die regulären Bereiche eine Mehrzahl von Auswahlleitungen mit zugeordneten Speicherzellen aufweisen und die redundanten Bereiche eine Mehrzahl von redundanten Auswahlleitungen mit zugeordneten Speicherzellen aufweisen.

Moderne dynamische Halbleiterspeicher, DRAMs (DRAM = dynamic random access memory = dynamischer Speicher mit wahlfreiem Zugriff), sind durchweg mit redundanten Speicherzellen ausgelegt, um Speicherzellen, die während eines Prüfvorgangs als defekte Speicherzellen erkannt wurden, durch nicht-defekte, funktionsfähige Speicherzellen ersetzen zu können. Bei neuen Produkten wird es so überhaupt erst möglich, funktionsfähige Bauelemente bzw. Bausteine zu produzieren, und auch bei reiferen Produkten wird hierdurch eine dramatische Steigerung der Ausbeute bei der Herstellung solcher Produkte erzielt.

Die Ersetzung der Speicherzellen erfolgt jedoch nicht einzeln, sondern durch eine Umadressierung vollständiger Zeilen oder Spalten einer Zellmatrix. Hierbei sind Randbedingungen hinsichtlich der Blockbildung in Ersetzungsbereiche und bezüglich der Anzahl der dort verfügbaren redundanten Zeilen und Spalten zu beachten. Die Suche nach einer vollständigen Abdeckung, die sog. Redundanzanalyse, wird bei komplexeren Fehlerbildern zu einer aufwendigen Optimierungsaufgabe.

Für das Auffinden einer vollständigen Abdeckung eines gegebenen Fehlerbildes durch redundante Zeilen und Spalten in einem matrixförmig organisierten Speicherzellenfeld gibt es keine geschlossenen Lösungsformeln. Die Lösungssuche besteht im Durchprobieren verschiedener Rekonfigurationen, wobei die Suche vollständig ist, wenn sie alle theoretisch möglichen Rekonfigurationen umfasst. Um effizient zu sein, müssen unter den möglichen Rekonfigurationen schnell diejenigen erkannt werden, die wahrscheinlich eine Abdeckung gewährleisten, und die Probierreihenfolge ist entsprechend diesen Wahrscheinlichkeiten zuzuordnen. Hierdurch ist es möglich, in praktischen Fällen von astronomisch großen Zahlen auf nur wenige tatsächliche'Probierschritte zu kommen. Solche Verfahren sind allgemein bekannt und nicht Gegenstand dieser Erfindung. Diese Verfahren werden beispielsweise von Chin-Long Wey, et. al. in IEEE Transactions on Computer Aided Design, Band 6, S. 222-231, 1987 beschrieben.

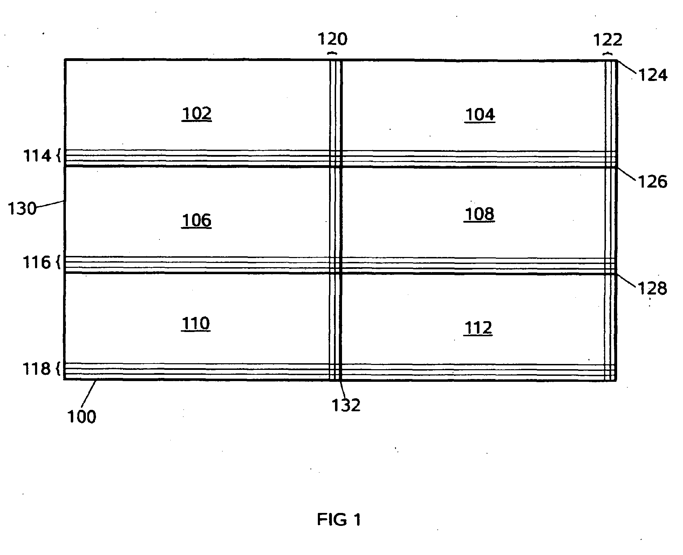

Fig. 1 zeigt ein Beispiel für ein matrixförmiges Speicherzellenelement eines Speichers mit einer herkömmlichen blockorientierten (segmentierten) Redundanz. Das in Fig. 1 gezeigte matrixförmige Speicherzellenfeld 100 umfasst sechs Blöcke 102, 104, 106, 108, 110, 112. In jedem der Blöcke 102 bis 112 ist eine Vielzahl von einzelnen Speicherzellen matrixförmig angeordnet, die über in Fig. 1 nicht gezeigte Auswahlleitungen, bestehend aus Wortleitungen und Bitleitungen, aufgerufen und aktiviert werden können, um Daten in dieselben zu schreiben oder aus denselben wiederzugewinnen. Zusätzlich umfasst jeder der Blöcke 102 bis 112 drei redundante Zeilen/Wortleitungen 114, 116, 118. Ferner umfasst jeder Block 102 bis 112 zwei redundante Spalten/Bitleitungen 120, 122.

Das in Fig. 1 gezeigte matrixförmige Speicherzellenfeld 100 weist eine traditionell blockorientierte Redundanz auf. Das Speicherzellenfeld 100 ist in drei Zeilenblöcke unterteilt, die durch die Blöcke 102 und 104, 106 und 108 sowie 110 und 112 gebildet sind. Jedem der drei Zeilenblöcke sind die redundanten Zeilen/Wortleitungen 114, 116 bzw. 118 zugeordnet. Das Speicherzellenfeld 100 ist ferner in zwei Spaltenblöcke unterteilt, die durch die Blöcke 102, 106, 110 sowie 104, 108, 112 gebildet sind.

Die redundanten Wortleitungen 114, 116, 118 können in senkrechter Richtung bis zur nächsten Blockgrenze 124, 126, 128 verwendet werden. Mit anderen Worten können die redundanten Wortleitungen 114 in den Blöcken 102 und 104 eingesetzt werden, also im ersten Zeilenblock. Analog können die redundanten Wortleitungen 116 bzw. 118 in den Zeilenblöcken 106, 108 bzw. 110, 112 eingesetzt werden.

Die redundanten Bitleitungen 120, 122 können in waagrechter Richtung bis zu den Blockgrenzen 130 und 132 eingesetzt werden, die redundanten Bitleitungen 120 also bis zur Blockgrenze 130 für den Block 102, den Block 106 und den Block 110. Analog können die redundanten Bitleitungen 122 für die Blöcke 104, 108 und 112 verwendet werden.

Entscheidend für die Verwendbarkeit des anhand der Fig. 1 beschriebenen matrixförmigen Speicherzellenfeldes mit traditionell blockorientierter Redundanz unter Verwendung eines herkömmlichen Redundanzanalysators ist, dass in Ersetzungsrichtung eines Leitungstyps, also einer Wortleitung oder einer Bitleitung, keine Blockgrenzen 124 bis 132 des orthogonalen Leitungstyps überschritten werden. Im Stand der Technik sind Redundanzanalysatoren bekannt, die Lösungen für Redundanzarchitekturen zuverlässig auffinden, bei denen die Blöcke in einer Richtung der Zellmatrix ein oder mehrere Blöcke in orthogonaler Richtung vollständig überstreichen, wie dies gerade anhand der Fig. 1 erläutert wurde.

Neben den gerade beschriebenen Speicherzellenfeldern mit traditionell blockorientierter Redundanz existieren auch flexiblere, sogenannte blockfreie Redundanzarchitekturen, die hinsichtlich eines möglichst geringen Platzverbrauchs und höchstmöglicher Ausbeute reparierbarer Bausteine Vorteile gegenüber dem anhand der Fig. 1 beschriebenen Ansatz bieten. Solche Architekturen verletzen das anhand der Fig. 1 beschriebene Blockbildungskriterium, so dass mit Redundanzanalysatoren gemäß dem Stand der Technik nicht mehr für jedes Fehlerbild eine vollständige Fehlerabdeckung auffindbar ist, auch wenn diese existiert. Die Ursache liegt darin, dass, wenn redundante Leitungen selbst fehlerhaft sind, das effektive Fehlerbild durch die Lösung verändert wird.

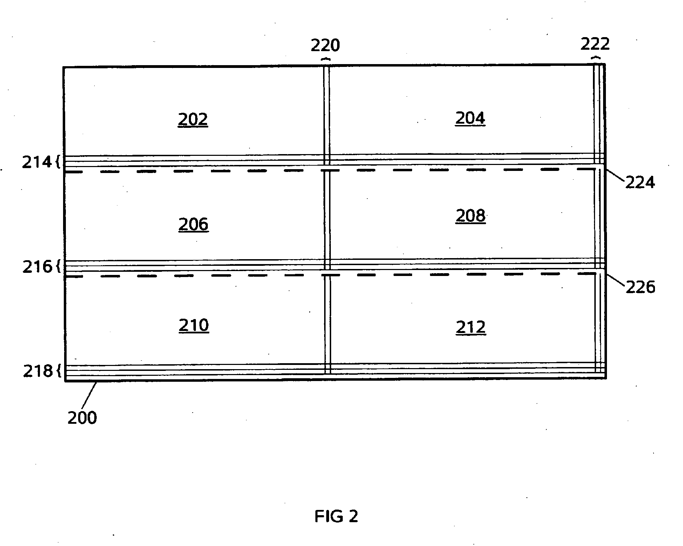

Die blockfreie Redundanzarchitektur wird nachfolgend anhand der Fig. 2 näher erläutert, die ein matrixförmiges Speicherzellenfeld 200 zeigt, mit einer Mehrzahl von Blöcken 202 bis 212, in denen die Speicherzellen des Speicherzellenfeldes angeordnet sind, wobei den Speicherzellen Auswahlleitungen (nicht dargestellt) zugeordnet sind. Ähnlich wie in Fig. 1 weist das Speicherzellenfeld 200 eine Mehrzahl von redundanten Wortleitungen 214 bis 218 sowie eine Mehrzahl von redundanten Bitleitungen 220 und 222 auf. Durch die gestrichelten Linien 224 und 226 ist eine Blockbildung für die redundanten Spalten/Bitleitungen 220, 222 angedeutet, wobei die redundanten Spalten/Bitleitungen 220, 222 frei in waagrechter Richtung an unabhängigen Adressen in den verschiedenen Blöcken eingesetzt werden können, wie dies durch die Darstellung der Bitleitungen 220, 222 als jeweils nicht-durchgezogene Linie schematisch angedeutet ist. Das matrixförmige Speicherzellenfeld 200 ist entsprechend der blockfreien Redundanz gebildet, was bedeutet, dass alle neun redundanten Zeilen/Wortleitungen 214 bis 218 in senkrechter Richtung frei eingesetzt werden.

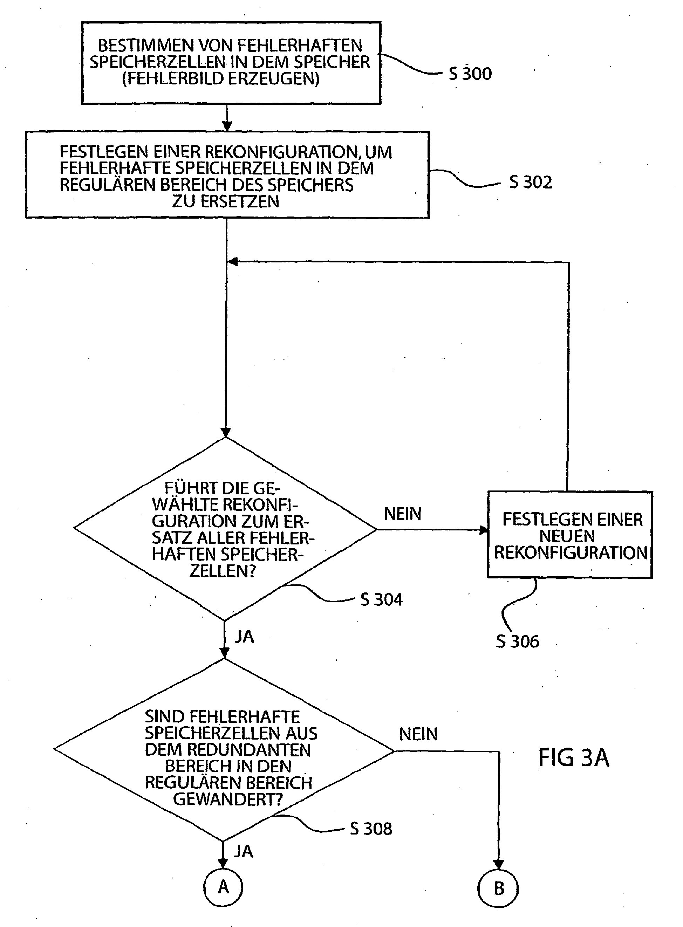

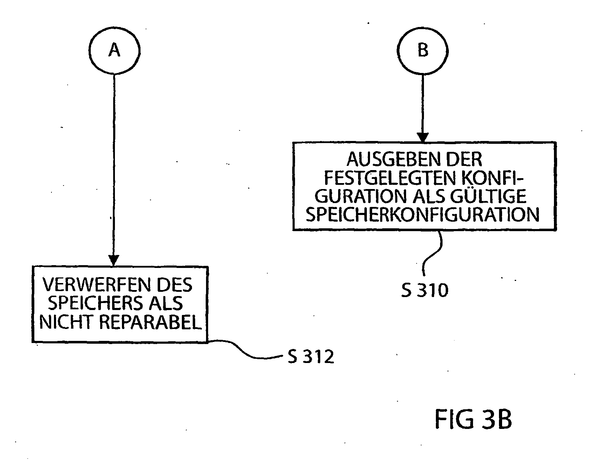

Das für eine Rekonfiguration zum Ersetzen von fehlerhaften Speicherzellen in einem Speicher gemäß dem Stand der Technik angewandte Verfahren wird nachfolgend anhand der Fig. 3A und 3B näher erläutert. Unter Rekonfiguration wird gemäß der vorliegenden Erfindung die Umadressierung von gültigen Zeilen- und Spaltenadressen des regulären Bereichs des Speichers in den redundanten Bereich des Speichers verstanden.

In einem ersten Schritt S300 wird zunächst der Speicher/das Speicherzellenfeld (einschließlich redundanter Bereiche) geprüft, um fehlerhafte Speicherzellen in dem Speicher/Speicherzellenfeld 200 zu bestimmen (Fehlerbild). Das Fehlerbild wird abgespeichert und im Schritt S302 wird durch einen Redundanzanalysator versuchsweise eine erste Rekonfiguration der zur Verfügung stehenden redundanten Auswahlleitungen (Wort- und Bitleitungen) gewählt, die festlegt welche der redundanten Wortleitungen 214 bis 218 und/oder welche der redundanten Bitleitungen 220, 222, fehlerbehaftete Wort- oder Bitleitungen in den einzelnen Blöcken 202 bis 212 ersetzen sollen.

Im Schritt S304 wird überprüft, ob durch diese Rekonfiguration alle fehlerhaften Speicherzellen in dem regulären Bereich ersetzt sind. Ist dies nicht der Fall, so wird im Schritt S306 eine neue Rekonfiguration festgelegt, um die fehlerhaften Speicherzellen zu ersetzen und das Verfahren geht dann zurück zum Schritt S304. Diese Schleife stellt den Kern eines herkömmlicher Redundanzanalyseverfahrens dar und wird solange durchlaufen, bis entweder eine vollständige Fehlerabdeckung gefunden ist oder ein Abbruchkriterium für die Schleife erreicht und der Speicher als irreparabel verworfen wird.

Bei der Überprüfung im Schritt S304 wird angenommen, dass das Fehlerbild selbst durch die Rekonfiguration nicht verändert worden ist. Diese Annahme ist bei einer traditionellen Blockbildung (Segmentierung) gemäß Fig. l immer erfüllt. Bei einer blockfreien Redundanzarchitektur gemäß Fig. 2 kann diese Annahme verletzt werden, wenn redundante Leitungen selbst fehlerbehaftet sind. Voraussetzung für einen erfolgreichen Einsatz herkömmlicher Redundanzanalyseverfahren zusammen mit einer blockfreien Redundanz ist deshalb die Garantie, dass die ersetzenden Zeilen/Spalten, also die redundanten Wortleitungen/Bitleitungen selbst, fehlerfrei sind. Diese Annahme wird in der Wirklichkeit jedoch mit endlicher Wahrscheinlichkeit verletzt, werden. Sind im redundanten Teil des Speicherzellenfeldes selbst Fehler vorhanden, sind den redundanten Auswahlleitungen also fehlerhafte Speicherzellen zugeordnet, so kann eine anscheinende Lösung, die ein konventioneller Redundanzanalysator anbietet, Fehler aus dem redundanten Bereich in den Adressbereich des Hauptzellenfeldes versetzen und unabgedeckt lassen. Dieser Zustand ergibt sich nach dem Durchlaufen der anhand der Fig. 3 beschriebenen Verfahrensschritte S300 bis S304.

Um dieses Problem zu lösen, schlägt der Stand der Technik bei blockfreier Redundanz vor, zusätzlich zur Verwendung des herkömmlichen Redundanzanalysators, anschließend die gefundene Lösung auf unabgedeckt gebliebene Fehler hin zu untersuchen, die durch "gewanderte" Defekte auf redundanten Leitungen verursacht werden können. Dies ist in Fig. 3 durch den Schritt S308 dargestellt. Wurde im Schritt S304 bestimmt, dass alle Fehler in dem regulären Bereich ersetzt wurden, wird im Schritt S308 festgestellt, ob fehlerhafte Speicherzellen aus dem redundanten Bereich in den regulären Bereich gewandert sind. Ist dies nicht zutreffend, wird die Rekonfiguration im Schritt S310 als Lösung ausgegeben. Ergibt sich, dass Fehler unabgedeckt geblieben sind, so wird der Speicherbaustein im Schritt S3212 als irreparabel verworfen.

Bei einem erweiterten Verfahren werden die Schritte S302 bis S308 als erste Lösungsstufe betrachtet, und in einer zweiten Lösungsstufe wird bestimmt, ob die unabgedeckt gebliebenen Fehler durch noch nicht verwendete redundante Auswahlleitungen abgedeckt werden können. Ist dies möglich, so wird die Lösung, also die Rekonfiguration des Speichers, entsprechend erweitert. Andernfalls wird der Speicherbaustein als irreparabel verworfen.

Das zuletzt beschriebene, bekannte zweistufige Lösungsverfahren ist dahingehend nachteilhaft, dass die erste Stufe nichts über die Kriterien weiß, nach der die zweite Stufe arbeitet, so dass unter Umständen tatsächlich reparierbare Bausteine/Speicherbauelemente verworfen werden. Dies liegt daran, dass der Analysator in der ersten Stufe eine Lösung anbieten kann, die zu der Situation führt, dass keine weiteren redundanten Leitungen mehr vorhanden sind, welche ein Abdecken übrig gebliebener Fehler auf den verwendeten redundanten Leitungen zuließe, obwohl eine alternative Lösung möglich gewesen wäre, mit der alle Fehler hätten abgedeckt werden können. Es ist wünschenswert, den verbliebenen, theoretisch vermeidbaren Ausbeuteverlust auch praktisch auszuschalten.

Ausgehend von diesem Stand der Technik liegt der vorliegenden Erfindung die Aufgabe zugrunde, ein verbessertes Verfahren zur Rekonfiguration eines Speichers zu schaffen, um die Ausbeute bei der Herstellung von Speicherelementen zu steigern.

Diese Aufgabe wird durch ein Verfahren nach Anspruch 1 und durch ein Verfahren nach Anspruch 4 gelöst.

Die vorliegende Erfindung schafft ein Verfahren zur Rekonfiguration eines Speichers, um fehlerhafte Speicherzellen in einer Mehrzahl von Blöcken des Speichers durch redundante Speicherzellen zu ersetzen, wobei jeder Block eine Mehrzahl von ersten und zweiten regulären Auswahlleitungen mit zugeordneten Speicherzellen und eine Mehrzahl von ersten und zweiten redundanten Auswahlleitungen mit zugeordneten Speicherzellen umfasst, durch die die ersten und zweiten regulären Auswahlleitungen ersetzbar sind, wobei die ersten redundanten Auswahlleitungen eines Block in zumindest einem anderen Block des Speichers einsetzbar sind, wobei fehlerhafte Speicherzellen der in einen anderen Block verschobenen ersten redundanten Auswahlleitungen durch zweite redundante Auswahlleitungen des anderen Blocks ersetzbar sind, und wobei das Verfahren folgende Schritte umfasst: (a) Bestimmen eines Fehlerbildes; (b) Rekonfigurieren des Speichers, um fehlerhafte Speicherzellen zu ersetzen; (c) Bestimmen, ob durch die Rekonfiguration im Schritt (b) zumindest eine erste redundante Auswahlleitung mit fehlerhaften Speicherzellen aus einem Block in einen anderen Block verschoben wurde; (d) falls eine oder mehrere erste redundante Auswahlleitungen mit fehlerhaften Speicherzellen aus einem Block in einen anderen Block verschoben wurden, Zuordnen der verschobenen ersten redundanten Auswahlleitungen mit fehlerhaften Speicherzellen zu dem anderen Block; (e) Bestimmen, ob das Fehlerbild durch die Rekonfiguration unter Berücksichtigung der Zuordnung aus Schritt (d) abgedeckt wird; und (f) falls das Fehlerbild abgedeckt wird, Ausgeben der Rekonfiguration als gültige Lösung.

Die vorliegende Erfindung schafft ein Verfahren zur Rekonfiguration eines Speichers, um fehlerhafte Speicherzellen in einer Mehrzahl von Blöcken des Speichers durch redundante Speicherzellen zu ersetzen, wobei jeder Block eine Mehrzahl von ersten und zweiten regulären Auswahlleitungen mit zugeordneten Speicherzellen und eine Mehrzahl von ersten und zweiten redundanten Auswahlleitungen mit zugeordneten Speicherzellen umfasst, durch die die ersten und zweiten regulären Auswahlleitungen ersetzbar sind, wobei die ersten redundanten Auswahlleitungen eines Block in zumindest einem anderen Block des Speichers einsetzbar sind, wobei fehlerhafte Speicherzellen der in einen anderen Block verschobenen ersten redundanten Auswahlleitungen durch zweite redundante Auswahlleitungen des anderen Blocks ersetzbar sind, und wobei das Verfahren folgende Schritte umfasst: (a) Bestimmen eines Fehlerbildes; (b) Bestimmen, ob ersten redundanten Auswahlleitungen eine oder mehrere fehlerhafte Speicherzellen zugeordnet sind; (c) falls den ersten redundanten Auswahlleitungen fehlerhafte Speicherzellen zugeordnet sind, Verteilen und Zuordnen der ersten redundanten Auswahlleitungen mit fehlerhaften Speicherzellen auf die Mehrzahl der Blöcke entsprechend einer vorgegebenen Regel; (d) Durchführen einer Redundanzanalyse des Fehlerbildes, wobei die im Schritt (c) verteilten ersten redundanten Auswahlleitungen für diese Redundanzanalyse den Blöcken fest zugeordnet sind; (e) Bestimmen, ob das Fehlerbild abgedeckt wird; und (f) falls das Fehlerbild abgedeckt wird, Ausgeben einer durch die Redundanzanalyse festgelegten Rekonfiguration als gültige Lösung.

Der vorliegenden Erfindung liegt die Erkenntnis zugrunde, dass eine vollständige Lösung für das anhand der Fig. 3 beschriebene Problem und somit eine Ausbeutesteigerung bei der Produktion von Speicherelementen, z. B. DRAMs, erreicht werden kann, indem die im Stand der Technik bekannte zweistufige Analyse durch eine integrierte Analyse ersetzt wird. Diese integrierte Analyse berücksichtigt die besondere Blockbildung der blockfreien Redundanzarchitektur.

Gemäß einem Ausführungsbeispiel werden die Schritte (c) bis (e) bis zum Auffinden einer Lösung wiederholt, so dass das erfindungsgemäße Verfahren erschöpfend ist, was bedeutet, dass es immer zu einer Fehlerabdeckung führt, wenn eine solche existiert, wobei die Lösungssuche lediglich mit der für alle Redundanzanalysatoren geltenden Einschränkung durchgeführt wird, dass sie nicht länger als eine vorgegebene Zeit dauern darf und beim Überschreiten derselben abgebrochen wird. Praktische Untersuchungen haben jedoch gezeigt, dass in realistischen Systemen mit sinnvoll gewählten Zeitschranken die Häufigkeit der letztgenannten Fälle vernachlässigbar gering ist.

Der Speicher umfasst einen oder mehrere reguläre (nicht-redundante) Bereiche mit einer Mehrzahl von Speicherzellen und redundante Bereiche mit einer Mehrzahl von redundanten Speicherzellen, wobei die regulären Bereiche eine Mehrzahl von Auswahlleitungen mit zugeordneten Speicherzellen aufweisen, und die redundanten Bereiche eine Mehrzahl von redundanten Auswahlleitungen mit zugeordneten Speicherzellen aufweisen, die den regulären Bereichen blockfrei zugeordnet werden können.

Der Vorteil der vorliegenden Erfindung ist darin zu sehen, dass, anders als bei herkömmlichen Verfahren, Speicher, die noch reparabel sind, nicht aufgrund des Analyseverfahrens fälschlicherweise als irreparabel eingestuft und verworfen werden, so dass eine entsprechende Ausbeutesteigerung erreicht werden kann.

Die vorliegende Erfindung ist auf jeden matrixförmig organisierten Speicherbaustein anwendbar, der durch Zeilen- und Spaltenumadressierungen rekonfigurierbar ist und eine blockfreie Redundanz aufweist, beispielsweise auf dynamische Halbleiterspeicher.

Für große Speicher mit vielen redundanten Elementen (z. B. für Speicher mit 64MB Speicherelementen mit etwa 4% redundanten Elementen) wird eine effiziente Implementierung des erfindungsgemäßen Verfahrens auf eine Programmierung leistungsfähiger Rechenprozessoren angewiesen sein.

Bevorzugte Ausführungsbeispiele der vorliegenden Anmeldung werden nachfolgend unter Bezugnahme auf die beiliegenden Zeichnungen näher erläutert. Es zeigen:
Fig. 1 ein matrixförmiges Speicherzellenfeld eines Speichers mit einer herkömmlich blockorientierten Redundanz;
Fig. 2 ein matrixförmiges Speicherzellenfeld eines Speichers mit einer blockfreien Zeilen-Redundanz;
Fig. 3A und 3B ein Flussdiagramm, das ein bekanntes Verfahren zur Rekonfiguration des in Fig. 2 beschriebenen Speicherzellenfeldes zeigt, um fehlerhafte Speicherzellen zu ersetzen;
Fig. 4A und 4B ein Flussdiagramm, das das erfindungsgemäße Verfahren zum Ersetzen fehlerhafter Speicherzellen gemäß einem ersten Ausführungsbeispiel der vorliegenden Erfindung beschreibt;
Fig. 5A und 5B ein Flussdiagramm, das das erfindungsgemäße Verfahren zum Ersetzen fehlerhafter Speicherzellen gemäß einem zweiten Ausführungsbeispiel der vorliegenden Erfindung beschreibt; und
Fig. 6A bis 6F eine Beschreibung der einzelnen Verfahrensschritte des erfindungsgemäßen Verfahrens gemäß dem zweiten Ausführungsbeispiel aus Fig. 5 anhand einer beispielhaften, fehlerhaften Speicherkonfiguration.

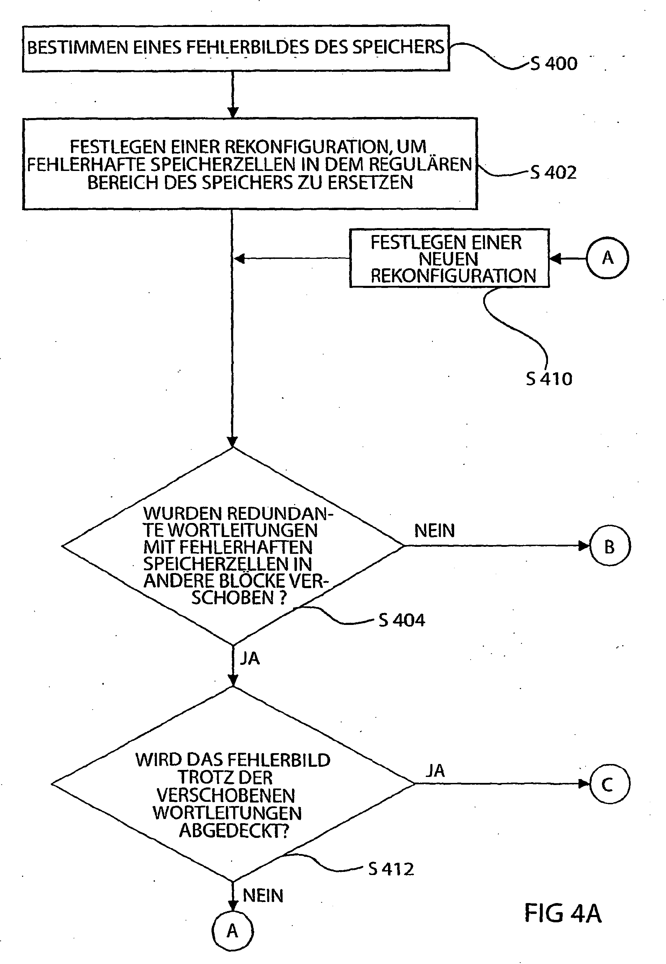

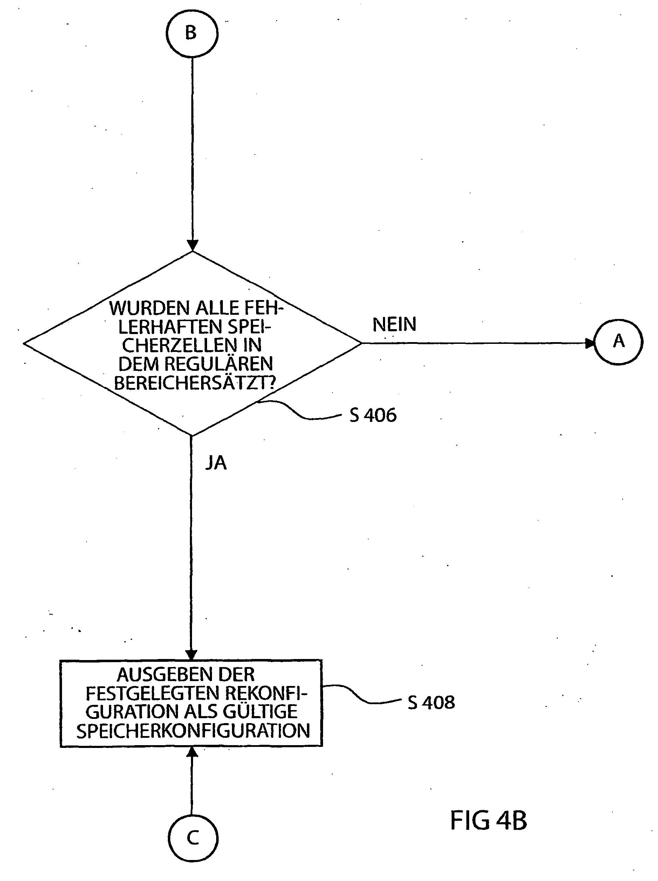

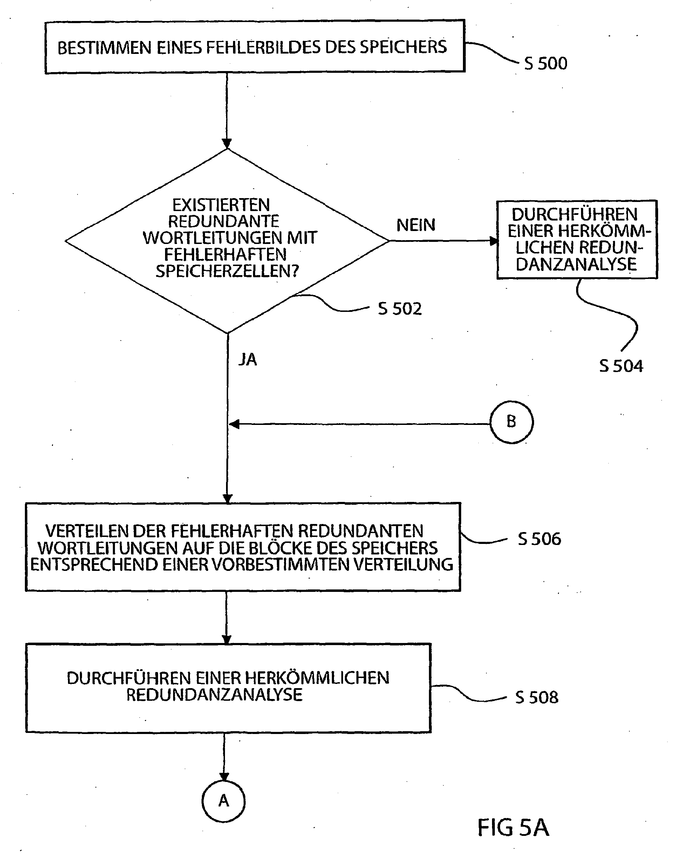

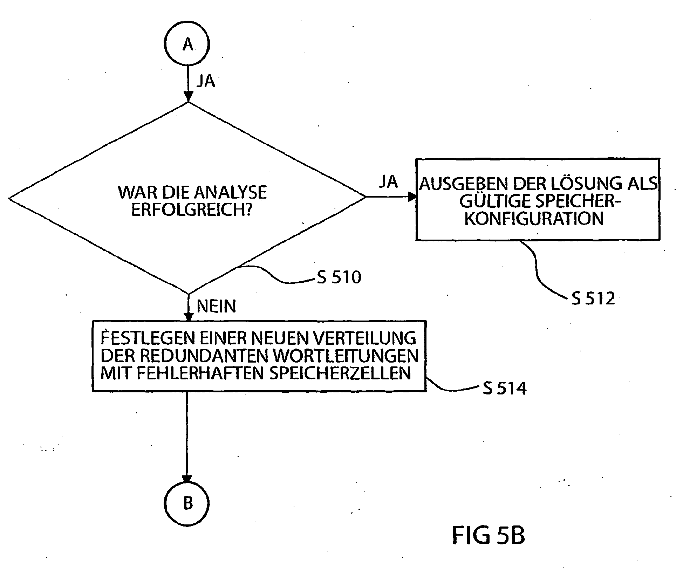

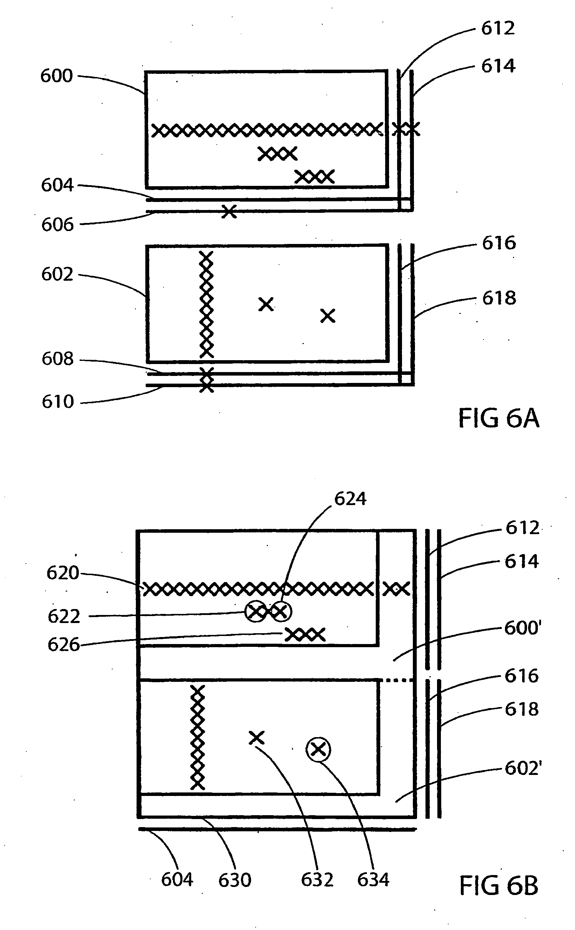

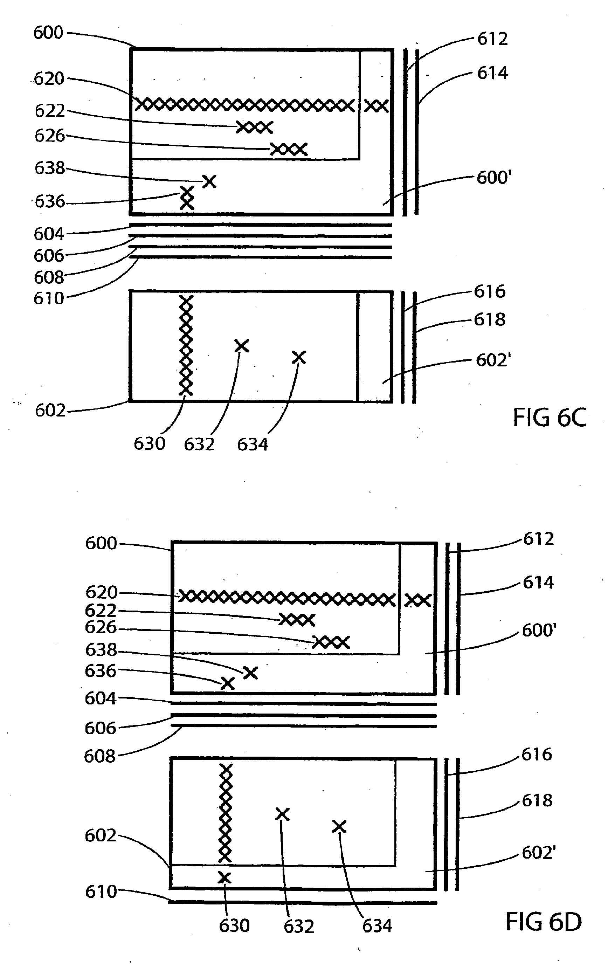

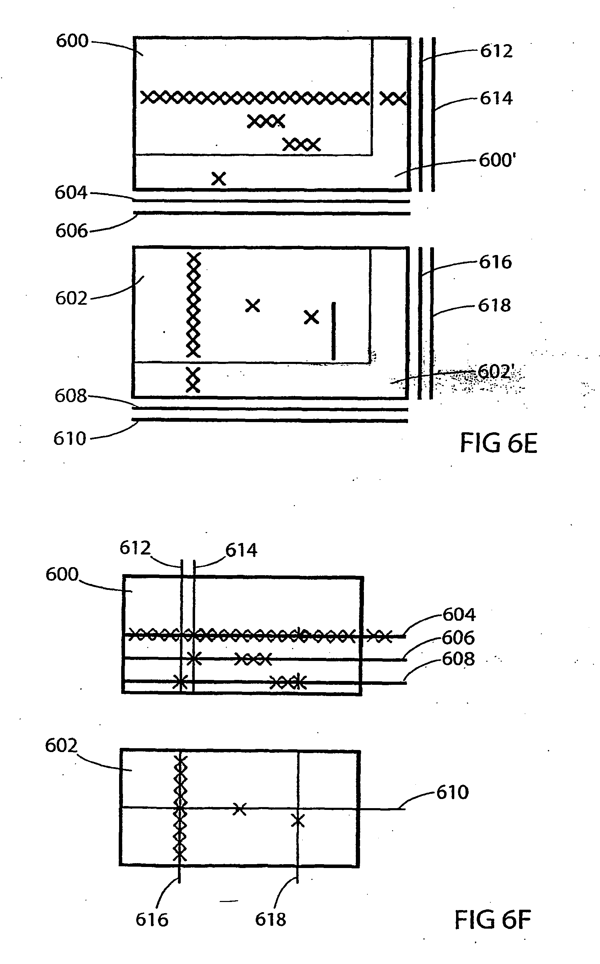

Das erfindungsgemäße Verfahren wird nachfolgend anhand der Fig. 4A, 4B, 5A und 5B näher erläutert, wobei später, anhand der Fig. 6, ein bevorzugtes Ausführungsbeispiel des erfindungsgemäßen Verfahrens gemäß Fig. 5 beschrieben wird. In der nachfolgenden Beschreibung der bevorzugten Ausführungsbeispiele der vorliegenden Erfindung wird von einem Speicher ausgegangen, der eine Mehrzahl von Blöcken aufweist. Jeder Block hat eine Mehrzahl von regulären Wortleitungen und regulären Bitleitungen mit zugeordneten Speicherzellen und eine Mehrzahl von redundanten Wortleitungen und redundanten Bitleitungen mit zugeordneten Speicherzellen, durch die die regulären Wort- und Bitleitungen ersetzbar sind. Die redundanten Wortleitungen eines Blocks sind in zumindest einem anderen Block des Speichers einsetzbar. Fehlerhafte Speicherzellen der in einen anderen Block verschobenen redundanten Wortleitungen sind durch redundante Bitleitungen des anderen Blocks ersetzbar.

In einem ersten Schritt S400 wird - ähnlich wie bei dem anhand der Fig. 3 beschriebenen Verfahren - ein Fehlerbild des zu untersuchenden Speichers bestimmt (regulärer und redundanter Bereich), um fehlerhafte Speicherzellen zu erfassen. Bei Vorliegen von fehlerhaften Speicherzellen in den regulären Bereichen des Speichers wird im Schritt S402 eine Rekonfiguration festgelegt, um diese fehlerhaften (fehlerbehafteten) Speicherzellen in dem regulären Bereich durch nicht-fehlerhafte Speicherzellen aus dem redundanten Bereich zu ersetzen.

Anschließend wird im Schritt S404 bestimmt, ob durch die vorhergehende Rekonfiguration eine oder mehrere redundante Wortleitungen mit fehlerhaften Speicherzellen von den ursprünglichen Blöcken in andere Blöcke verschoben wurden. Trifft dies nicht zu, so wird im Schritt S406 (Fig. 4B) bestimmt, ob durch die Rekonfiguration das Fehlerbild abgedeckt ist, ob also alle fehlerhaften Speicherzellen in dem regulären Bereich des Speichers durch funktionsfähige Speicherzellen ersetzt wurden. Ist dies der Fall, so endet das Verfahren beim Schritt S408 mit der Ausgabe der Lösung, der derzeit gültigen Rekonfiguration, als gültige Speicherkonfiguration.

Andernfalls, wenn also nicht alle fehlerhaften Speicherzellen in dem regulären Bereich ersetzt wurden, geht das Verfahren zum Schritt S410 (Fig. 4A), in dem eine neue Rekonfiguration ausgewählt wird, anhand der die fehlerhaften Speicherzellen zu ersetzen sind, und das Verfahren kehrt zurück zum Schritt S404.

Wurde im Schritt S404 festgestellt, dass redundante wortleitungen mit fehlerhaften Speicherzellen in andere Blöcke verschoben wurden, so werden diese verschobenen redundanten Wortleitungen den neuen Blöcken zugeordnet und im Schritt S412 wird festgestellt, ob das Fehlerbild durch die Rekonfiguration trotz der verschobenen fehlerhaften redundanten Wortleitungen abgedeckt wird. Ist dies zutreffend, dann geht das Verfahren zum Schritt S408 (Fig. 4B), um die Rekonfiguration als gültige Speicherkonfiguration auszugeben.

Wurde im Schritt S412 festgestellt, dass das Fehlerbild nicht abgedeckt wird, geht das Verfahren zurück zum Schritt S410, um eine neue Konfiguration festzulegen.

Nachfolgend wird anhand der Fig. 5A und 5B ein zweites Ausführungsbeispiel der vorliegenden Erfindung erläutert. Hier wird von einem Speicher ausgegangen, der auch dem anhand der Fig. 4 beschriebenen ersten Ausführungsbeispiel zugrunde gelegen hat.

In einem ersten Schritt S500 wird - ähnlich wie bei dem anhand der Fig. 4 beschriebenen Verfahren - ein Fehlerbild des zu untersuchenden Speichers bestimmt (regulärer und redundanter Bereich), um fehlerhafte Speicherzellen zu erfassen. Bei Vorliegen von fehlerhaften Speicherzellen in den regulären Bereichen des Speichers wird im Schritt S502 bestimmt, ob redundante Wortleitungen existieren, denen fehlerhafte Speicherzellen zugeordnet sind. Ist dies nicht der Fall, so wird im Schritt S504 eine herkömmliche Redundanzanalyse durchgeführt und die erhaltene Lösung ausgegeben.

Sind redundante Wortleitungen mit fehlerhaften Speicherzellen vorhanden, so werden die in einem Schritt S506 entsprechend einer vorbestimmten Regel auf die einzelnen Blöcke des Speichers verteilt. Die Verteilung kann zunächst das Ignorieren aller redundanten Wortleitungen mit fehlerhaften Speicherzellen umfassen, kann abhängig von der Anzahl der redundanten Wortleitungen mit fehlerhaften Speicherzellen erfolgen, und/oder die redundanten Wortleitungen mit fehlerhaften Speicherzellen werden auf die Blöcke abhängig von einer Wahrscheinlichkeit, mit der eine Verteilung zu einer Lösung führt, verteilt.

Nachfolgend wird im Schritt S508 eine herkömmliche Redundanzanalyse durchgeführt, wobei die verteilten redundanten Wortleitungen für diese Redundanzanalyse den Blöcken, auf die dieselben verteilt wurden, fest zugeordnet sind.

Im Schritt S510 (Fig. 5B) wird festgestellt, ob diese herkömmliche Redundanzanalyse erfolgreich war. Ist dies zutreffend, dann geht das Verfahren zum Schritt S512, um die Lösung als gültige Speicherkonfiguration auszugeben. Wurde im Schritt S510 ein Misserfolg der herkömmlichen Redundanzanalyse festgestellt (es wurde für die Verteilung keine Lösung aufgefunden), wird im Schritt S514 eine neue Verteilung der redundanten Wortleitungen mit fehlerhaften Speicherzellen auf die Blöcke festgelegt, und das Verfahren geht zurück zum Schritt S506.

Anhand der Fig. 6 wird nachfolgend das anhand der Fig. 5 beschriebene Ausführungsbeispiel näher erläutert, insbesondere die erforderlichen Schritte, um unter Berücksichtigung von fehlerhaften Speicherzellen, die den verwendeten redundanten Wortleitungen zugeordnet sind, zu bestimmen, ob ein Ersetzen aller fehlerhaften Speicherzellen in dem regulären Bereich des Speicherzellenfeldes mittels einer gegebenen Verteilung der redundanten Wortleitungen möglich ist oder nicht.

Eine konkrete Implementierung des erfindungsgemäßen Verfahrens verlangt eine sehr effiziente Auswahl unter den theoretisch möglichen Rekonfigurationen, da jeder noch so leistungsfähige Prozessor bei heute üblichen Speichergrößen und Redundanzarchitekturen mit blindem Durchprobieren inakzeptabel lange für die Lösungssuche brauchen würde. Anhand der Fig. 6 wird nachfolgend ein Beispiel mit einer blockfreien Zeilenredundanzarchitektur und ein Ausführungsbeispiel der vorliegenden Erfindung näher betrachtet. Bei diesem Ausführungsbeispiel werden zur Ersetzung mögliche Verteilungen der redundanten Wortleitungen betrachtet.

In Fig. 6A ist das ursprüngliche Fehlerbild dargestellt, wobei hier ein Ausschnitt eines Speicherzellenfeldes gezeigt ist. In Fig. 6A ist ein Speicherzellenfeld mit einem ersten Block 600 und einem zweiten Block 602 dargestellt, wobei mit dem Zeichen "X" fehlerhafte Speicherzellen schematisch angedeutet sind. Dem ersten Block 600 sind zwei redundante Wort/Zeilenleitungen (im folgenden Wortleitungen) 604 und 606 zugeordnet, und dem zweiten Block 602 sind zwei redundante Wortleitungen 608 und 610 zugeordnet. Ferner sind dem ersten Block 600 zwei redundante Bit/Spaltenleitungen (im folgenden Bitleitungen) 612 und 614 zugeordnet, und dem zweiten Block 602 sind ferner zwei redundante Bitleitungen 616 und 618 zugeordnet.

In einem ersten Schritt wird zunächst überprüft, ob redundante Wortleitungen existieren, denen fehlerhafte Speicherzellen zugeordnet sind, ob also Fehler auf redundanten Wortleitungen vorliegen. Sollte festgestellt werden, dass alle redundanten Wortleitungen keine Fehler aufweisen, so wird mit einem herkömmlichen Redundanzanalyseverfahren fortgefahren.

Bei dem anhand der Fig. 6A beschriebenen Beispiel wird jedoch festgestellt, dass die redundanten Bitleitungen 612 und 614 sowie die redundanten Wortleitungen 606, 608 und 610 fehlerhaft sind, also dass diesen redundanten Auswahlleitungen fehlerhafte Speicherzellen zugeordnet sind, wie dies in den Figuren durch das Zeichen "X" verdeutlicht ist.

In einem ersten Lösungsschritt werden die redundanten Wortleitungen mit Fehlern ignoriert und es wird versucht, eine Lösung der fehlerhaften Speicherkonfiguration unter Verwendung der verbliebenen redundanten Wortleitungen ohne Fehler zu finden. Diese Situation ist in Fig. 6B dargestellt, bei der die mit Fehlern behafteten Wort leitungen 606, 608, 610, "ausgeblendet" sind, und lediglich die fehlerfreie redundante Wortleitung 604 und die redundante Bitleitungen 612, 614, 616 und 618 verblieben sind. Die Bitleitungen 612 und 614, die in Fig. 6A noch mit fehlerhaften Speicherzellen gezeigt waren, wurden "logisch" korrigiert, indem die fehlerhaften Speicherzellen einem erweiterten Block 600' zugeordnet wurden.

Zur Korrektur der Bitleitungen 612 und 614 wird in Fig. 6B die Wortleitung 604 herangezogen, um die Wortleitung 620 im ersten Block 600 zu ersetzen, wodurch auch die den Bitleitungen 612 und 614 in dieser Zeile zugeordneten, fehlerhaften Speicherzellen ersetzt werden, so dass die Bitleitungen 612 und 614 herangezogen werden können, um andere fehlerhafte Speicherzellen in dem Block 600 zu ersetzen.

Es wird darauf hingewiesen, dass die Verschiebung der einzelnen Auswahlleitungen in Fig. 6 nur aus Gründen der Vereinfachung der Erläuterung des erfindungsgemäßen Verfahrens dargestellt ist, tatsächlich jedoch keine Änderung des physikalischen Layouts des Speicherzellenfeldes stattfindet. Vielmehr erfolgt die entsprechende Zuordnung der redundanten Auswahlleitungen nach dem Auffinden einer Konfiguration, die alle Fehler beseitigt, basierend auf einem entsprechend erzeugten Datensatz anhand herkömmlicher Techniken.

Die in Fig. 6B dargestellte Konfiguration, bei der die fehlerhaften redundanten Wortleitungen ignoriert wurden, führt zu keiner Lösung, da die verbliebenen redundanten Wort- und Bitleitungen keine Abdeckung aller fehlerhaften Speicherelemente in den regulären Bereichen der Blöcke ermöglichen.

So wird über die redundante Wortleitung 604, wie erwähnt, die fehlerhafte Zeile 620 im ersten Block 600 ersetzt, so dass über die Bitleitungen 612 und 614 ein Teil der Zeile 622 ersetzt werden könnte. Die fehlerhafte Speicherzelle 624 in Zeile 622 könnte jedoch genauso wenig ersetzt werden wie die fehlerhaften Speicherzellen in Zeile 626. Ebenso könnten im zweiten Block 602 mittels der Bitleitungen 616 und 618 die fehlerbehafteten Spalten 630 und 632 ersetzt werden, ein Ersatz der fehlerhaften Speicherzelle 634 wäre jedoch nicht möglich.

Mit der in Fig. 6B dargestellten Lösung, nämlich dem Ignorieren der fehlerhaften redundanten Wortleitungen und dem Versuch, mit der verbleibenden fehlerfreien redundanten Wortleitung unter Heranziehung der redundanten Bitleitungen eine Lösung zu finden, also alle fehlerhaften Speicherelemente zu ersetzen, führt nicht zum Erfolg.

Nachdem die in Fig. 6B dargestellte Lösung nicht erfolgreich war, werden in nachfolgenden Schritten mögliche verteilungen der fehlerbehafteten (defekten) redundanten Wortleitungen auf die Blöcke 600, 602 ausgewählt.

Bei jeder ausgewählten Verteilung werden die redundanten Wortleitungen mit Fehlern verteilt und eine gewöhnliche Redundanzanalyse wird durchgeführt. Sofern diese nicht erfolgreich ist, wird eine nächste Verteilung der fehlerhaften oder defekten redundanten Wortleitungen auf die Blöcke ausgewählt und erneut eine Redundanzanalyse durchgeführt, solange, bis eine Lösung gefunden ist, die dann als gültige Speicherkonfiguration ausgegeben wird, oder bis festgestellt wird, dass alle möglichen Verteilungen durchprobiert worden sind und aufgrund der Fehlerhäufigkeit der Speicher als irreparabel einzustufen ist.

In Fig. 6C ist eine erste mögliche Verteilung der defekten redundanten Wortleitungen 606 bis 610 auf die Blöcke dargestellt, wobei die in Fig. 6C gezeigte Verteilung derart ist, dass alle fehlerhaften redundanten Wortleitungen dem ersten Block 600 zugeordnet sind, dieser Block also virtuell vergrößert wird (erweiterter Block 600').

Ähnlich wie in Fig. 6B wird, um die Bitleitungen 612 und 614 zu korrigieren, auch in Fig. 6C die Wortleitung 604 herangezogen, um die Wortleitung 620 im ersten Block 600 zu ersetzen, wodurch auch die den Bitleitungen 612 und 614 in dieser Zeile zugeordneten, fehlerhaften Speicherzellen ersetzt werden, so dass die Bitleitungen 612 und 614 herangezogen werden können, um andere fehlerhafte Speicherzellen in dem Block 600 zu ersetzen. Die korrigierten, redundanten Bitleitungen 612 und 614 werden herangezogen, um die Spalten 636 und 638 im ersten Block 600 zu ersetzen, wodurch die den redundanten Wortleitungen 606, 608, 610.zugeordneten fehlerhaften Speicherzellen ersetzt werden, so dass diese Wortleitungen für eine Korrektur wieder herangezogen werden können.

Die in Fig. 6C dargestellte Verteilung führt jedoch auch nicht zu einer Lösung, also zu keinem Ersatz aller fehlerhaften Speicherzellen. Im Block 600 wäre eine Überbrückung aller fehlerhaften Speicherelemente möglich. Hier wird die fehlerhafte Zeile 620 durch die redundante Wortleitung 604 ersetzt. Die Spalten 636 und 638 werden durch die redundanten Bitleitungen 612 und 614 ersetzt, wodurch die Wortleitungen 606, 608 und 610 wieder verfügbar werden, so dass die Zeilen 622 und 626 durch die Wort leitungen 606 und 608 ersetzt werden, wodurch alle fehlerhaften Speicherzellen in dem ersten Block 600 ersetzt sind. Die Wortleitung 610 wird nicht benötigt. Somit ließe sich für den Block 600 eine Lösung (Rekonfiguration) finden, bei der alle fehlerhaften Speicherzellen im regulären Bereich ersetzt wurden, jedoch eröffnet die dargestellte Verteilung keine Lösung für den Block 602, da hier für eine Umadressierung lediglich die Bitleitungen 616 und 618 zur Verfügung stehen, so dass z.B. nur die Spalten 630 und 632 ersetzt werden können, die fehlerhafte Speicherzelle 634, wie auch schon in Fig. 6B, jedoch als nicht ersetzbar zurückbleibt.

Nachdem die anhand der Fig. 6C dargestellte Verteilung zu keiner Lösung führt, muss eine andere Verteilung aufgefunden werden. Eine weitere Verteilung der fehlerhaften Wortleitungen ist in Fig. 6D gezeigt, bei der zwei fehlerhafte redundante Wortleitungen 606, 608 dem Block 600 (erweiterter Block 600') und eine fehlerhafte redundante Wortleitung 610 dem Block 602 (erweiterter Block 602') zugeordnet sind. Wie aus Fig. 6D zu erkennen ist, sind dem ersten Block 600 die fehlerfreie, redundante Wortleitung 604 sowie die weiteren fehlerbehafteten, redundanten Wortleitungen 606 und 608 zugeordnet. Dem zweiten Block 600 ist die fehlerbehaftete, redundante Wortleitungen 610 zugeordnet.

Ähnlich wie in Fig. 6C wird, um die Bitleitungen 612 und 614 zu korrigieren, auch in Fig. 6D die Wortleitung 604 herangezogen, um die Wortleitung 620 im ersten Block 600 zu ersetzen, wodurch auch die den Bitleitungen 612 und 614 in dieser Zeile zugeordneten, fehlerhaften Speicherzellen ersetzt werden, so dass die Bitleitungen 612 und 614 herangezogen werden können, um andere fehlerhafte Speicherzellen in dem Block 600 zu ersetzen. Die korrigierten, redundanten Bitleitungen werden herangezogen, um die Spalten 636 und 638 im ersten Block 600 zu ersetzen, wodurch die den redundanten Wortleitungen 606 und 608 zugeordneten fehlerhaften Speicherzellen ersetzt werden, so dass diese Wortleitungen für eine Korrektur wieder herangezogen werden können. Ebenso wird im zweiten Block 602 eine der Bitleitungen 616 oder 618 herangezogen, um die Spalte 630 zu ersetzen, wodurch die der redundanten Wortleitung 610 zugeordnete fehlerhafte Speicherzelle ersetzt wird, so dass diese Wortleitung für eine Korrektur im Block 602 wieder herangezogen werden können.

An dieser Stelle sei nochmals darauf hingewiesen, dass die Wortleitungen nach deren Zuordnung zu einem der Blöcke nur noch innerhalb dieses Blocks für eine Korrektur fehlerhafter Speicherzellen herangezogen werden können. Eine Verwendung über Blockgrenzen hinweg ist nicht mehr möglich.

Die in Fig. 6D dargestellte Konfiguration führt zu einer Lösung, da hier sämtliche fehlerhaften Speicherzellen in den Blöcken 600 und 602 ersetzt werden können. Genauer gesagt, wird die fehlerhafte Zeile 620 durch die redundante Wortleitung 604 ersetzt, die fehlerhafte Zeile 622 wird durch die korrigierte, redundante Wortleitung 606 ersetzt, und die fehlerhaften Zeile 626 wird durch die korrigierte, redundante Wortleitung 608 ersetzt, so dass alle im ersten Block 600 vorhandenen fehlerhaften Speicherzellen durch nicht-fehlerhafte Speicherzellen ersetzt sind.

Auch im zweiten Block 602 können alle fehlerhaften Speicherzellen ersetzt werden. Die fehlerhafte Spalte 630 wird durch die redundante Bitleitung 616 ersetzt, die Spalte 632 wird durch die korrigierte redundante Wortleitung 610 ersetzt, und die bisher nicht ersetzbare Speicherzelle 634 wird durch die redundante Bitleitung 618 ersetzt.

Somit sind alle in den Blöcken 600 und 602 liegenden, fehlerhaften regulären Speicherzellen durch nicht-fehlerhafte Speicherzellen ersetzt. Fig. 6F zeigt diese Lösung schematisch, wobei die eingezeichneten redundanten Wortleitungen lediglich andeuten, dass die diesen Anschlussleitungen zugeordneten Zeilen/Spalten durch die entsprechenden redundanten Wortleitungen ersetzt wurden, so dass alle in den Blöcken 600, 600' und 602, 602' liegenden, fehlerhaften Speicherzellen durch fehlerfreie Speicherzellen ersetzt sind, der Speicher also vollständig "repariert" wurde.

Zusätzlich zu den in Fig. 6C und 6D gezeigten möglichen Verteilungen der defekten redundanten Wortleitungen auf die Blöcke 600 und 602 ist in Fig. 6E eine dritte mögliche Verteilung gezeigt, bei der eine fehlerhafte redundante Wortleitung 606 auf den ersten Block 602 verteilt wurde und zwei fehlerhafte redundante Wortleitungen 608, 610 auf den zweiten Block verteilt wurden. Die in Fig. 6E dargestellte Verteilung führt zu keiner Lösung, wie sich aufgrund der obigen Ausführungen ohne weiteres nachvollziehen lässt, und dient lediglich zur Verdeutlichung der verschiedenen Möglichkeiten, wie die einzelnen fehlerhaften redundanten Wortleitungen auf die verschiedenen Blöcke verteilt werden können.

Obwohl anhand von Fig. 6 ein Ausführungsbeispiel beschrieben wurde, bei dem lediglich die fehlerhaften redundanten Wortleitungen auf die verschiedenen Blöcke verteilt wurden, ist die vorliegenden Erfindung nicht hierauf beschränkt, da bei anderen Blockkonfigurationen, wie beispielsweise nebeneinanderliegenden Blöcken, eine entsprechende Verteilung von redundanten Bitleitungen, analog zu dem anhand der Fig. 6 beschriebenen Ausführungsbeispiel, durchgeführt werden kann. Ferner kann bei einer weitergehenden Konfiguration von beispielsweise vier matrixförmig angeordneten Blöcken eine Kombination herangezogen werden, bei der sowohl die fehlerhaften redundanten Wortleitungen als auch die fehlerhaften redundanten Bitleitungen während der Analyseschritte auf verschiedene Blöcke verteilt werden, um eine Lösungen aufzufinden.

### Bezugszeichenliste

- 100: matrixförmiges Zellenelement
- 102-112: Blöcke
- 114-122: redundante Adressleitungen
- 124-132: Blockgrenzen
- 200: matrixförmiges Zellenelement
- 202-212: Blöcke
- 214-222: redundante Adressleitungen
- 224, 226: Blockgrenzen
- S300-S312: Verfahrensschritte
- S400-S412: Verfahrensschritte
- S500-S514: Verfahrensschritte
- 600: erster Block
- 600': erweiterter erster Block
- 602: zweiter Block
- 602': erweiterter zweiter Block
- 604-610: redundante Wortleitung
- 612-618: redundante Bitleitung
- 620, 622: Zeile
- 624: fehlerhafte Speicherzelle
- 626: Zeile
- 630, 632: Spalte
- 634: fehlerhafte Speicherzelle
- 636, 638: Spalte

## Patentansprüche

1. Verfahren zur Rekonfiguration eines Speichers (200), um fehlerhafte Speicherzellen (X) in einer Mehrzahl von Blöcken (600, 602) des Speichers (200) durch redundante Speicherzellen zu ersetzen,
wobei jeder Block eine Mehrzahl von ersten und zweiten regulären Auswahlleitungen mit zugeordneten Speicherzellen und eine Mehrzahl von ersten und zweiten redundanten Auswahlleitungen (214-222; 604-618) mit zugeordneten Speicherzellen umfasst, durch die die ersten und zweiten regulären Auswahlleitungen mit ihren zugeordneten Zellen ersetzbar sind,
wobei die ersten redundanten Auswahlleitungen eines Blocks in zumindest einem anderen Block des Speichers (200) als Ersatz verwendet werden können,
wobei fehlerhafte Speicherzellen (X) der in einem anderen Block verwendeten ersten redundanten Auswahlleitungen durch zweite redundante Auswahlleitungen des anderen Blocks ersetzbar sind, und
wobei das Verfahren folgende Schritte umfasst:
(a) Bestimmen eines Fehlerbildes (S400);
(b) Rekonfigurieren des Speichers (200), um fehlerhafte Speicherzellen (X) zu ersetzen (S402);
(c) Bestimmen, ob durch die Rekonfiguration im Schritt (b) zumindest eine erste redundante Auswahlleitung mit fehlerhaften Speicherzellen aus einem Block in einem anderen Block verwendet wird (S404);
(d) falls eine oder mehrere erste redundante Auswahlleitungen mit fehlerhaften Speicherzellen aus einem Block in einem anderen Block verwendet werden, Zuordnen dieser fehlerhaften Speicherzellen zu dem anderen Block;
(e) Bestimmen, ob das Fehlerbild durch die Rekonfiguration unter Berücksichtigung der Zuordnung aus Schritt (d) abgedeckt wird (S412); und
(f) falls das Fehlerbild abgedeckt wird, Ausgeben der Rekonfiguration als gültige Lösung (S408).

2. Verfahren nach Anspruch 1, mit folgendem Schritt nach dem Schritt (e):
Falls das Fehlerbild nicht abgedeckt wird, Durchführen der Schritte (b) bis (f) mit einer neuen Konfiguration.

3. Verfahren nach Anspruch 1 oder 2, mit folgenden Schritten nach dem Schritt (c):
falls keine ersten redundanten Auswahlleitungen mit fehlerhaften Speicherzellen aus einem Block in einem anderen Block verwendet werden,
(i) Bestimmen, ob das Fehlerbild durch die Rekonfiguration abgedeckt wird (S406),
(ii) falls das Fehlerbild abgedeckt wird, Ausgeben der Rekonfiguration als gültige Lösung (S408), und
(iii) falls das Fehlerbild nicht abgedeckt wird, Wiederholen der Schritte (b) bis (f) mit einer neuen Rekonfiguration.

4. Verfahren zur Rekonfiguration eines Speichers (200), um fehlerhafte Speicherzellen (X) in einer Mehrzahl von Blöcken (600, 602) des Speichers (200) durch redundante Speicherzellen zu ersetzen,
wobei jeder Block eine Mehrzahl von ersten und zweiten regulären Auswahlleitungen mit zugeordneten Speicherzellen und eine Mehrzahl von ersten und zweiten redundanten Auswahlleitungen (214-222; 604-618) mit zugeordneten Speicherzellen umfasst, durch die die ersten und zweiten regulären Auswahlleitungen mit ihren zugeordneten Zellen ersetzbar sind,
wobei die ersten redundanten Auswahlleitungen eines Blocks in zumindest einem anderen Block des Speichers (200) als Ersatz verwendet werden können,
wobei fehlerhafte Speicherzellen (X) der in einem anderen Block verwendeten ersten redundanten Auswahlleitungen durch zweite redundante Auswahlleitungen des anderen Blocks ersetzbar sind, und
wobei das Verfahren folgende Schritte umfasst:
(a) Bestimmen eines Fehlerbildes (S500);
(b) Bestimmen, ob ersten redundanten Auswahlleitungen eine oder mehrere fehlerhafte Speicherzellen zugeordnet sind (S502);
(c) falls den ersten redundanten Auswahlleitungen fehlerhafte Speicherzellen zugeordnet sind, Verteilen und Zuordnen der ersten redundanten Auswahlleitungen mit fehlerhaften Speicherzellen auf die Mehrzahl der Blöcke entsprechend einer vorgegebenen Regel (S506);
(d) Durchführen einer Redundanzanalyse des Fehlerbildes, wobei die im Schritt (c) verteilten ersten redundanten Auswahlleitungen für diese Redundanzanalyse den Blöcken fest zugeordnet sind (S508);
(e) Bestimmen, ob das Fehlerbild abgedeckt wird (510); und
(f) falls das Fehlerbild abgedeckt wird, Ausgeben einer durch die Redundanzanalyse festgelegten Rekonfiguration als gültige Lösung (S512).

5. Verfahren nach Anspruch 4, mit folgendem Schritt nach dem Schritt (e):
falls das Fehlerbild nicht abgedeckt wird, Wiederholen der Schritte (c) bis (f) mit einer neuen Verteilung und Zuordnung der ersten redundanten Auswahlleitungen mit fehlerhaften Speicherzellen auf die Mehrzahl der Blöcke.

6. Verfahren nach Anspruch 4 oder 5, mit folgenden Schritten nach dem Schritt (c):
falls den ersten redundanten Auswahlleitungen keine fehlerhaften Speicherzellen zugeordnet sind,
(i) Durchführen einer Redundanzanalyse des Fehlerbildes (S504),
(ii) Bestimmen, ob das Fehlerbild abgedeckt wird;
(iii) falls das Fehlerbild abgedeckt wird, Ausgeben einer durch die Redundanzanalyse festgelegten Rekonfiguration als gültige Lösung, und
(iv) falls das Fehlerbild nicht abgedeckt wird, Wiederholen der Schritte (i) bis (iv) mit einer neuen Konfiguration.

7. Verfahren nach einem der Ansprüche 4 bis 6, bei dem der Schritt (c) das Ignorieren aller ersten redundanten Auswahlleitungen (606, 608, 610) mit fehlerhaften Speicherzellen (X) umfasst.

8. Verfahren nach einem der Ansprüche 4 bis 6, bei dem im Schritt (c) die Verteilung abhängig von der Anzahl der ersten redundanten Auswahlleitungen mit fehlerhaften Speicherzellen erfolgt.

9. Verfahren nach einem der Ansprüche 4 bis 6, bei dem im Schritt (c) die Zuordnung der ersten redundanten Auswahlleitungen mit fehlerhaften Speicherzellen zu den Blöcken abhängig von einer Wahrscheinlichkeit, mit der eine Verteilung zu einer Lösung führt, erfolgt.

10. Verfahren nach einem der Ansprüche 1 bis 9, bei dem die Speicherzellen matrixförmig angeordnet sind, wobei die ersten regulären Auswahlleitungen reguläre Wortleitungen und die zweiten regulären Auswahlleitungen reguläre Bitleitungen sind, und wobei die ersten redundanten Auswahlleitungen redundante Wortleitungen und die zweiten redundanten Auswahlleitungen redundante Bitleitungen sind, wobei die redundanten Wortleitungen in Spaltenrichtung über Blockgrenzen (224, 226) hinweg als Ersatz verwendbar sind, und wobei die redundanten Bitleitungen in Zeilenrichtung über Blockgrenzen hinweg als Ersatz verwendbar sind.

## Claims

1. Method for reconfiguring a memory (200), in order to replace faulty memory cells (X) in a plurality of blocks (600, 602) of the memory (200) by redundant memory cells,
where each block comprises a plurality of first and second regular select lines with corresponding memory cells and a plurality of first and second redundant select lines (214-222; 604-618) with corresponding memory cells which can replace the first and second regular select lines and their corresponding cells,
where the first redundant select lines of one block can be used for replacement in at least one other block of the memory (200),
where defective memory cells (X) of the first redundant select lines which have been used in one block can be replaced by second redundant select lines of the other block, and
where the method comprises the following steps:
(a) determining a fault pattern (S400);
(b) reconfiguring (S402) the memory (200), in order to replace faulty memory cells (X) ;
(c) determining whether the reconfiguration in step (b) has resulted in at least one first redundant select line with faulty memory cells from one block being used in another block (S404);
(d) if one or more first redundant select lines with faulty memory cells from one block have been used in another block, assigning the faulty memory cells to the other block;
(e) determining (S412) whether the fault pattern is covered by the reconfiguration by taking into account the assignment in step (d); and
(f) if the fault pattern is covered, outputting the reconfiguration as a valid solution (S408).

2. Method according to claim 1, with the following step after the step (e):
if the fail pattern is not covered, perform the steps (b) to (f) with a new configuration.

3. Method according to claim 1 or 2, with the following steps after the step (c):
If no first redundant select lines with faulty memory cells from one block are used in another block,
(i) determining whether the fault pattern is covered by the reconfiguration (S406),
(ii) if the fault pattern is covered, outputting the reconfiguration as a valid solution (S408), and
(iii) if the fault pattern is not covered, repeating the steps (b) to (f) with a new reconfiguration.

4. Method for reconfiguring a memory (200), so as to replace faulty memory cells (X) in a plurality of blocks (600, 602) of the memory (200) by redundant memory cells,
wherein each block comprises a plurality of first and second regular select lines with corresponding memory cells and a plurality of first and second redundant select lines (214-222; 604-618) with corresponding memory cells which can replace the first and second regular select lines and their corresponding cells,
wherein the memory cells are arranged in the form of a matrix, wherein the first regular select lines are regular word lines and the second regular select lines are regular bit lines, and wherein the first redundant select lines are redundant word lines and the second redundant select lines are redundant bit lines, wherein the redundant word lines in column direction are utilisable beyond block boundaries, and wherein the redundant bit lines in row direction are utilisable beyond block boundaries.
wherein the first redundant select lines of one block can be used for replacement in at least one other block of the memory (200),
wherein defective memory cells (X) of the first redundant select lines which have been used in one block can be replaced by second redundant select lines of the other block, and
where the method comprises the following steps:
(a) determining a fault pattern (S500);
(b) determining whether first redundant select lines have one or more faulty memory cells attached (S502);
(c) if the first redundant select lines have faulty memory cells attached, distributing and assigning the first redundant select lines with faulty memory cells among the plurality of blocks according to a prescribed rule (S506);
(d) performing a redundancy analysis of the fault pattern, with the first redundant select lines distributed in step (c) being fixedly assigned to the blocks for this redundancy analysis (S508);
(e) determining whether the fault pattern is covered (510); and
(f) if the fault pattern is covered, outputting a reconfiguration specified by the redundancy analysis as a valid solution (S512).

5. Method according to claim 4, with the following step after the step (e):
if the fault pattern has not been covered, repeating the steps (c) to (f) with a new distribution and assignment of the first redundant select lines with fault memory cells to the plurality of blocks.

6. Method according to claim 4 or 5, with the following steps after step (c):
if the first redundant select lines have no faulty memory cells attached,
(i) performing a redundancy analysis of the fault pattern (S504),
(ii) determining whether the fault pattern has been covered;
(iii) if the fault pattern has been covered, outputting as a valid solution a reconfiguration as specified by the redundancy analysis, and
(iv) if the fault pattern has not been covered, repeating the steps (i) to (iv) with a new configuration.

7. Method according to one of the claims 4 to 6, in which the step (c) comprises ignoring all the first redundant select lines (606, 608, 610) with faulty memory cells (X).

8. Method according to one of the claims 4 to 6, where in step (c) the distribution is chosen depending on the number of first redundant select lines with faulty memory cells.

9. Method according to one of the claims 4 to 6, where in step (c) the assignment to the blocks of the first redundant select lines with faulty memory cells takes place depending on a probability with which a distribution leads to a solution.

10. Method according to one of the claims 1 to 9, wherein the memory cells are arranged in the form of a matrix, wherein the first regular select lines are regular word lines and the second regular select lines are regular bit lines, and wherein the first redundant select lines are redundant word lines and the second redundant select lines are redundant bit lines, wherein the redundant word lines in column direction are utilisable across block boundaries (224, 226), and wherein the redundant bit lines in row direction are utilisable across block boundaries.

## Revendications

1. Procédé pour la reconfiguration d'une mémoire (200) dans le but de substituer des cellules de mémoire défectueuses (X) dans une pluralité de blocs (600, 602) de la mémoire (200) par des cellules de mémoire redondantes,
chaque bloc comprenant une pluralité de premières et de secondes lignes de sélection régulières dotées de cellules de mémoire associées et une pluralité de premières et de secondes lignes de sélection redondantes (214-222; 604-618) dotées de cellules de mémoire associées, par lesquelles les premières et secondes lignes de sélection régulières sont substituables avec leurs cellules associées,
les premières lignes de sélection redondantes d'un bloc pouvant être utilisées dans au moins un autre bloc de la mémoire (200) en tant que substitut,
les cellules de mémoire défectueuses (X) des premières lignes de sélection redondantes utilisées dans un autre bloc étant substituables par des secondes lignes de sélection redondantes de l'autre bloc, et
le procédé comprenant les étapes suivantes:
(a) déterminer un modèle d'erreur (S400);
(b) reconfigurer la mémoire (200) afin de substituer les cellules de mémoire défectueuses (X) (S402);
(c) déterminer si, en raison de la reconfiguration réalisée à l'étape (b), au moins une première ligne de sélection redondante comprenant des cellules de mémoire défectueuses d'un bloc est utilisée dans un autre bloc (S404);
(d) au cas où une ou plusieurs premières lignes de sélection redondantes comprenant des cellules de mémoire défectueuses d'un bloc soient utilisées dans un autre bloc, affectation de ces cellules de mémoire défectueuses à l'autre bloc;
(e) déterminer si le modèle d'erreur est couvert par la reconfiguration en tenant compte de l'affectation réalisée à l'étape (d) (S412); et
(f) au cas où le modèle d'erreur soit couvert, sortie de la reconfiguration comme solution valide (S408).

2. Procédé selon la revendication 1, comprenant l'étape suivante selon l'étape (e):
au cas où le modèle d'erreur ne soit pas couvert, exécution des étapes (b) à (f) à l'aide d'une nouvelle configuration.

3. Procédé selon la revendication 1 ou 2, comprenant les étapes suivantes selon l'étape (c):
au cas où aucune première ligne de sélection redondante comprenant des cellules de mémoire défectueuses d'un bloc soit utilisée dans un autre bloc,
(i) déterminer si le modèle d'erreur est couvert par la reconfiguration (S406),
(ii) au cas où le modèle d'erreur soit couvert, sortie de la reconfiguration comme solution valide (S408), et
(iii) au cas où le modèle d'erreur ne soit pas couvert, répétition des étapes (b) à (f) à l'aide d'une nouvelle reconfiguration.

4. Procédé pour la reconfiguration d'une mémoire (200) afin de substituer des cellules de mémoire défectueuses (X) dans une pluralité de blocs (600, 602) de la mémoire (200) par des cellules de mémoire redondantes,
chaque bloc comprenant une pluralité de premières et de secondes lignes de sélection régulières dotées de cellules de mémoire associées et une pluralité de premières et de secondes lignes de sélection redondantes (214-222; 604-618) dotées de cellules de mémoire associées, par lesquelles les premières et secondes lignes de sélection régulières sont substituables avec leurs cellules associées,
les premières lignes de sélection redondantes d'un bloc pouvant être utilisées dans au moins un autre bloc de la mémoire (200) en tant que substitut,
les cellules de mémoire défectueuses (X) des premières lignes de sélection redondantes utilisées dans un autre bloc étant substituables par des secondes lignes de sélection redondantes de l'autre bloc, et
le procédé comprenant les étapes suivantes:
(a) déterminer un modèle d'erreur (S500);
(b) déterminer si une ou plusieurs cellules de mémoire défectueuses sont affectées à des premières lignes de sélection redondantes (S502);
(c) au cas où des cellules de mémoire défectueuses soient affectées aux premières lignes de sélection redondantes, répartition et affectation des premières lignes de sélection redondantes dotées de cellules de mémoire défectueuses à la pluralité des blocs conformément à une règle prédéfinie (S506);
(d) exécuter une analyse de redondance du modèle d'erreur, les premières lignes de sélection redondantes réparties à l'étape (c) étant affectées de manière fixe aux blocs pour cette analyse de redondance (S508);
(e) déterminer si le modèle d'erreur est couvert (510); et
(f) au cas où le modèle d'erreur soit couvert, sortie d'une reconfiguration, en tant que solution valide, déterminée par l'analyse de redondance (S512).

5. Procédé selon la revendication 4, comprenant l'étape suivante selon l'étape (e):
au cas où le modèle d'erreur ne soit pas couvert, répétition des étapes (c) à (f) à l'aide d'une nouvelle répartition et affectation des premières lignes de sélection redondantes, dotées de cellules de mémoire défectueuses, à la pluralité des blocs.

6. Procédé selon la revendication 4 ou 5, comprenant les étapes suivantes selon l'étape (c):
au cas où aucune cellule de mémoire défectueuse ne soit affectée aux premières lignes de sélection redondantes,
(i) exécuter une analyse de redondance du modèle d'erreur (S504),
(ii) déterminer si le modèle d'erreur est couvert;
(iii) au cas où le modèle d'erreur soit couvert, sortie d'une reconfiguration, en tant que solution valide, déterminée par l'analyse de redondance, et
(iv) au cas où le modèle d'erreur ne soit pas couvert, répétition des étapes (i) à (iv) à l'aide d'une nouvelle configuration.

7. Procédé selon l'une quelconque des revendications 4 à 6, dans lequel l'étape (c) comprend l'ignorance de toutes les premières lignes de sélection redondantes (606, 608, 610) dotées de cellules de mémoire défectueuses (X).

8. Procédé selon l'une quelconque des revendications 4 à 6, dans lequel à l'étape (c), la répartition est réalisée en fonction du nombre de premières lignes de sélection redondantes dotées de cellules de mémoire défectueuses.

9. Procédé selon l'une quelconque des revendications 4 à 6, dans lequel à l'étape (c), l'affectation des premières lignes de sélection redondantes dotées de cellules de mémoire défectueuses aux blocs est réalisée en fonction d'une probabilité, avec laquelle une répartition conduit à une solution.

10. Procédé selon l'une quelconque des revendications 1 à 9, dans lequel les cellules de mémoire sont disposées en forme de matrice, les premières lignes de sélection régulières étant des lignes de mots régulières et les secondes lignes de sélection régulières étant des lignes de bits régulières, et les premières lignes de sélection redondantes étant des lignes de mots redondantes et les secondes lignes de sélection redondantes étant des lignes de bits redondantes, les lignes de mots redondantes étant utilisables en tant que substitut au-delà de limites de bloc dans le sens des colonnes (224, 226), et les lignes de bits redondantes étant utilisables en tant que substitut au-delà de limites de bloc dans le sens des lignes.
